# EUROPÄISCHE PATENTANMELDUNG

(11) **EP 1 231 605 A2**
(43) Veröffentlichungstag der Anmeldung: **14.08.2002**
(21) Anmeldenummer: 02100082.3
(22) Anmeldetag: 30.01.2002
(51) Int. Cl.: G11C 5/00

(54) **Lademechanismus zum Be- und/oder Entladen eines elektronischen Gerätes mit mehr als einem Datenspeicher**

(30) Priorität: 01.02.2001 DE 10104363
(71) Anmelder: Philips Corporate Intellectual Property GmbH, 52066 Aachen (DE); Koninklijke Philips Electronics N.V., 5621 BA Eindhoven (NL)
(72) Erfinder: Kunze, Norbert, 52066, Aachen (DE); Müller, Stefan, 52066, Aachen (DE)
(74) Vertreter: Volmer, Georg, Dipl.-Ing.

(57) **Zusammenfassung**

Die Erfindung betrifft einen Lademechanismus zum Be - und/oder Entladen eines elektronischen Gerätes (1) mit mehr als einem Datenspeicher (2), die in Laufwerken elektronischer Geräte (1) mittels Lese- und/oder Schreibeinheiten gelesen und/oder beschrieben werden und die diesbezüglich keine beweglichen Teile besitzen, wobei das Be - und/oder Entladen des elektronischen Gerätes (1) über eine Ladeöffnung (3) erfolgt, die Dimensionierung der Ladeöffnung (3) auf die Dimensionierung des Datenspeichers (2) abgestimmt ist und ein Transportmechanismus (4) zum Transport des Datenspeichers (2) oder der Datenspeicher (2) zwischen einer Ladeposition und einer Spielposition dient.

## Beschreibung

Die Erfindung betrifft einen Lademechanismus zum Be- und/oder Entladen eines elektronischen Gerätes mit mehr als einem Datenspeicher. Ein weiterer Aspekt der Erfindung betrifft ein elektronisches Gerät zum Lesen und/oder Schreiben von Informationen auf Datenspeicher mit zumindest einem erfinderischen Lademechanismus.

Datenspeicher im Sinne der Erfindung sind Datenspeicher, die in Laufwerken elektronischer Geräte mittels Lese- und/oder Schreibeinheiten gelesen und/oder beschrieben werden können und die Lese- und/oder Schreibeinheiten keine beweglichen Teile besitzen. Solche Datenspeicher kommen regelmäßig in sog. solid - state - Geräte zum Einsatz Diese können sowohl ortsfeste als auch transportable elektrische Multimedia - Geräte sein, die die erforderliche Elektroenergie mittels Batterien oder jedweder anderen bekannten Art und Weise erhalten. Beispiele für solid - state - Geräte im Sinne der Erfindung sind: Audio - Video - Player, Organizer, Palmtops, elektronische Bücher oder Computer für Anwendungen im Bereich der privaten und geschäftlichen Verbraucher. Die Datenspeicher selbst, wie z B. Speicherkarten, besitzen in Bezug auf das Lesen oder Schreiben von Informationen regelmäßig keine beweglichen Teile. Datenspeicher im Sinne der Erfindung unterliegen bezüglich ihrer äußeren Form und des verwendeten Materials keinen Beschränkungen.

Solid - state - Geräte bzw. deren Lademechanismen zum Be- und/oder Entladen von mehreren solid - state - Datenspeichern sind u.a. durch die EP 0 744 751 A2 bekannt. Bei der dort beschriebenen Anwendung für einen Audio - Player sind eine vom Anwender gewünschte Anzahl von sog. Musik - Speicherkarten waagerecht auf einem Trägerelement anordenbar. Das Trägerelement ist aus einer Ladeposition über eine Ladeöffnung in eine Lagereinheit für die Musik - Speicherkarten mittels eines Lademechanismus in eine Spielposition bringbar. In dieser Spielposition sind die Musik - Speicherkarten mit dem Audio - Player elektronisch verbunden. Übersteigt die gewünschte Anzahl der einzubringenden Musik - Speicherkarten die Anzahl der auf einem Trägerelement positionierbaren Musik - Speicherkarten, wird ein zusätzliches Trägerelement eingesetzt. Die beschriebene Lösung bietet nur die Möglichkeit, in mehreren Lagereinheiten Trägerelemente übereinander anzuordnen. Die jeweilige Größe der Ladeöffnung korrespondiert regelmäßig mit der Größe des Trägerelementes. Mit zunehmender Anzahl der einzubringenden Musik - Speicherkarten erhöht sich die Anzahl der Trägerelemente schrittweise und somit auch die Bauhöhe des Audio - Players.

Sind mehrere Trägerelemente erforderlich, benötigen diese jeweils zumindest einen Lademechanismus und eine Ladeöffnung Neben dem vorgenannten gerätetechnischen Aufwand gibt es eine Vielzahl von Anwendungsfällen, bei welchen nur ein eng begrenzter Raum für die Positionierung der Ladeöffnung eines elektronischen Gerätes, z B. im Armaturenbrett eines PKW, zur Verfügung steht. In diesen Fällen ist ggf. nur Raum für eine Ladeöffnung bzw. eine bestimmte Größe der Ladeöffnung, d.h. die beschriebene Lösung ist dann nicht einsetzbar. Nachteilig wirkt sich auch aus, dass zum Zwecke des Entfernens einer Musik - Speicherkarte, das Trägerelement, mit allen anderen auf dieser angeordneten Musik - Speicherkarten, in die Ladeposition gebracht werden muss. Ein Zugriff, insbesondere zum Auslesen von Informationen von den anderen Musik - Speicherkarten, ist in der Ladeposition regelmäßig nicht möglich.

Aufgabe der Erfindung ist es, einen Lademechanismus der eingangs genannten Art bereit zu stellen, der bei vergleichsweise geringem gerätetechnischen Aufwand und bei geringem Raumbedarf für die Ladeöffnung realisierbar ist. Außerdem ist es Aufgabe der Erfindung ein elektrisches Gerät zum Lesen und/oder Schreiben von Informationen auf Datenspeicher zu schaffen, welches einen Lademechanismus der vorgenannten Art besitzt.

Die Aufgabe wird dadurch gelöst, dass ein Lademechanismus zum Be- und/oder Entladen eines elektronischen Gerätes mit mehr als einem Datenspeicher realisiert ist, die in Laufwerken elektronischer Geräte (1) mittels bekannter Lese- und/oder Schreibeinheiten gelesen und/oder beschrieben werden und die diesbezüglich keine beweglichen Teile besitzen, wobei das Be- und/oder Entladen des elektronischen Gerätes über eine Ladeöffnung erfolgt, die Dimensionierung der Ladeöffnung auf die Dimensionierung des Datenspeichers abgestimmt ist und ein Transportmechanismus zum Transport des Datenspeichers oder der Datenspeicher zwischen einer Ladeposition und einer Spielposition dient.

Die Elemente eines Lademechanismus zum Be- und/oder Entladen eines elektronischen Gerätes sind hinlänglich bekannt und beschrieben, wie beispielsweise in der DE 197 38 227 A1. Ein Lademechanismus der hier in Rede stehenden Art besitzt als wesentliche Elemente zumindest einen Transportmechanismus und eine Antriebseinheit. Die konkrete Ausführung des Lademechanismus wird insbesondere vom Verwendungszweck und den baulichen Gegebenheiten beeinflusst.

Die Ladeposition ist die Position, bei der der oder die Datenspeicher mit dem Transportmechanismus direkt oder indirekt, insbesondere form- oder kraftschlüssig, eine Verbindung eingehen. Die Spielposition kennzeichnet die Position des oder der Datenspeicher, in der diese drahtlos oder drahtgebunden mit der Lese- und/oder Schreibeinheit des elektrischen Gerätes in üblicher Art und Weise kommunizieren können. Drahtgebunden erfolgt das Kontaktieren beispielsweise mittels herkömmlicher Steckelemente, die in Eingriff gebracht werden.

Bevorzugt wird, dass der Lademechanismus ein Trägerelement besitzt, in dem ein Datenspeicher oder mehrere Dakenspeicher anordenbar sind. In der Ladeposition erfolgt regelmäßig das manuelle Be- bzw. Entladen des Trägerelementes mit Datenspeichern.

In einer weiteren bevorzugten Ausbildung der erfindungsgemäßen Lösung werden ein oder mehrere Trägerelemente, die mit einem Datenspeicher oder mehreren Datenspeichern beladen sind, vom Transportmechanismus in die Spielposition gebracht. Der Transportmechanismus kann dann vorzugsweise vom Trägerelement entkoppelt werden und befindet sich dann in einer Bereitschaftsposition. Von dieser Bereitschaftsposition aus ist es schnell möglich, sowohl in die Ladeposition als auch in eine Position zu gelangen, die geeignet ist, zur Entnahme von Datenspeichern aus der Spielposition zu dienen.

Gemäß einer alternativen bevorzugten Ausgestaltung der Erfindung werden die Datenspeicher - ohne im Trägerelement zu verbleiben oder in diesem angeordnet gewesen zu sein - in einem Magazin in die Spielposition gebracht. Die Verwendung eines Magazins ermöglicht das definierte Ablegen der Dakenspeicher auf engsten Raum. Dabei ist es grundsätzlich möglich, die Datenspeicher direkt vom Transportmechanismus ins Magazin überzuleiten oder diese in geeigneter Art und Weise aus dem Trägerelement ins Magazin zu verbringen.

Die Form und die Bauart des Magazins kann in an sich üblicher Weise an den jeweiligen Anwendungsfall angepasst werden. Im Sinne der Erfindung sind dies Magazine mit ein oder mehreren Ebenen zur Aufnahme von Datenspeichern, wobei die Ebenen waagerecht, senkrecht und/oder in jedweder anderen Art und Weise räumlich angeordnet sein können. Insbesondere in Abhängigkeit von der Form des Datenspeichers, insbesondere bezüglich seiner äußeren Kontur und Dimension, und des vorhandenen Einbauraumes kann die Ablage der Datenspeicher im Magazin realisiert werden. Die Verwendung von flexiblen Materialien insbesondere für die konturbestimmenden Teile des Datenspeichers, wie z. B. biegsame Folienwerkstoffe, ermöglichen runde oder zumindest gekrümmte Konturen des Magazins.

Im Magazin können sich grundsätzlich gleichzeitig mehrere Datenspeicher in einer Spielposition befinden, so dass ein gleichzeitiges Auslesen und/oder Beschreiben von mehreren Datenspeichern realisierbar ist.

Eine weitere bevorzugte Ausgestaltung der Erfindung betrifft die Dimensionierung der Ladeöffnung, die auf die Dimensionierung des Datenspeichers der Art abgestimmt ist, dass die kleinste Seitenfläche des Datenträgers die Dimensionierung der Größe der Ladeöffnung bestimmt. In Abhängigkeit von der jeweiligen äußeren Grundform des Dakenspeichers, wie beispielsweise eines Würfels oder eines Hexaeders, ist die Größe der Ladeöffnung bemessen. Die Größe der Ladeöffnung soll das Be- und/oder Entladen des elektrischen Gerätes problemlos ermöglichen und gleichzeitig entsprechend der jeweils gegebenen Raumverhältnissen so klein wie möglich dimensioniert sein. Die Anordnung der Ladeöffnung im elektrischen Geräte kann im Sinne der Erfindung waagerecht, senkrecht oder jeder anderen Anordnung erfolgen.

Ein Ausführungsbeispiel der Erfindung wird im folgenden anhand der Zeichnung näher erläutert. Es zeigt:

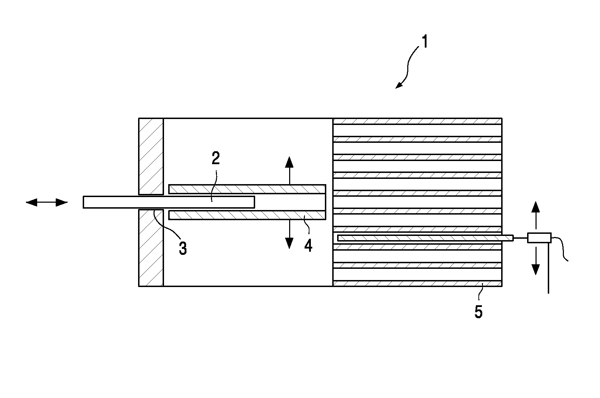

- Fig. 1: die schematische Seitenansicht eines elektrischen Gerätes mit einem Lademechanismus zum Be - und/oder Entladen von mehreren Datenspeichern.

In Figur 1 ist ein elektrisches Gerät 1, beispielsweise ein ortsfester Audio-Player, der in einem Armaturenbrett eines PKW angeordnet ist, schematisch dargestellt. Die verwendeten plattenförmigen Datenspeicher 2 sind im Ausführungsbeispiel über die Ladeöffnung 3, die hier schlitzförmig ausgebildet ist, mittels eines Transportmechanismus 4 horizontal einschieb- oder einziehbar. Die Dimensionierung der Ladeöffnung 3 ist der Art realisiert, dass die kleinste Seitenfläche des plattenförmigen Datenspeichers 2 die Größe der Ladeöffnung 3 bestimmt. D.h die Form der Ladeöffnung 3 entspricht der Form der kleinsten Seitenfläche des verwendeten Datenspeichers 2 und ist nur so groß, dass zumindest ein problemloses Beund/oder Entladen möglich ist.

Der Transportmechanismus 4, der u.a. eine übliche Antriebseinheit besitzt (nicht dargestellt), ist vertikal verfahrbar angeordnet, so dass er in der Ladeposition einen Datenspeicher 2 aufnehmen oder abgeben kann. Nach dem liftartigen Verfahren des beladenen Transportmechanismus 4 und dem gezielten Positionieren vor einer Öffnung des Magazins 5, in der sich kein Datenspeicher 2 befindet, erfolgt die Überleitung des Datenspeichers 2 ins Magazin 5. Der Transportmechanismus 4 befindet sich im unbeladenen Zustand in der Bereitschaftsposition. Das Magazin 5 ermöglicht die horizontale Einlagerung von jeweils einem Datenspeicher 2 in einer Etage des Magazins 5, wobei die Etagen des Magazins 5 übereinander angeordnet sind. Durch vertikales Verfahren, vorzugsweise an einer der drei anderen Seiten des Magazins 5, ist ein Kontaktelement jeweils dort anordenbar, wo zwischen einem ausgewählten Datenspeicher 2 und der Lese- und/oder Schreibeinheit des elektrischen Gerätes 1 eine übliche drahtgebundene Kommunikation in der Spielposition ermöglicht werden soll. Alternativ kann an jeder Etage des Magazins 5 ein Kontaktelement permanent angeordnet sein, so dass ein Auslesen und/oder Beschreiben von einem Datenspeicher 2 oder von mehreren Datenspeichern 2, ggf. gleichzeitig, realisierbar ist.

## Patentansprüche

1. Lademechanismus zum Be - und/oder Entladen eines elektronischen Gerätes (1) mit mehr als einem Datenspeicher (2), die in Laufwerken elektronischer Geräte (1) mittels Leseund/oder Schreibeinheiten gelesen und/oder beschrieben werden und die Lese- und/oder Schreibeinheiten keine beweglichen Teile besitzen, wobei das Be - und/oder Entladen des elektronischen Gerätes (1) über eine Ladeöffnung (3) erfolgt, die Dimensionierung der Ladeöffnung (3) auf die Dimensionierung des Datenspeichers (2) abgestimmt ist und ein Transportmechanismus (4) zum Transport des Datenspeichers (2) oder der Datenspeicher (2) zwischen einer Ladeposition und einer Spielposition dient.

2. Lademechanismus nach Anspruch 1,
**dadurch gekennzeichnet,**
**dass** ein oder mehrere Datenspeicher (2) in einem Trägerelement anordenbar sind.

3. Lademechanismus nach Anspruch 1,
**dadurch gekennzeichnet,**
**dass** ein oder mehrere Trägerelemente, die mit einem Datenspeicher (2) oder mehreren Datenspeichern (2) beladen sind, vom Transportmechanismus (4) in die Spielposition ablegbar sind.

4. Lademechanismus nach Anspruch 3,
**dadurch gekennzeichnet,**
**dass** ein oder mehrere Trägerelemente, die mit einem Datenspeicher (2) oder mehreren Datenspeichern (2) beladen sind, in einem Magazin (5) abgelegt sind.

5. Lademechanismus nach Anspruch 1,
**dadurch gekennzeichnet,**
**dass** der oder die Datenspeicher (2) im Magazin (5) in der Spielposition ablegbar sind.

6. Lademechanismus nach Anspruch 1,
**dadurch gekennzeichnet,**
**dass** Datenspeicher (2) oder Trägerelemente, die mit einem Datenspeicher (2) oder mehreren Datenspeichern (2) beladen sind, auf einer Ebene oder auf mehreren Ebenen im Magazin (5) ablegbar sind.

7. Lademechanismus nach Anspruch 6,
**dadurch gekennzeichnet,**
**dass** die Ebenen im Magazin (5) waagerecht, senkrecht und/oder in jedweder Art und Weise räumlich angeordnet sind.

8. Lademechanismus nach Anspruch 1,
**dadurch gekennzeichnet,**
**dass** der Transportmechanismus (4) sich nach dem Be - und/oder Entladen in einer Bereitschaftsposition befindet.

9. Lademechanismus nach Anspruch 1,
**dadurch gekennzeichnet,**
**dass** die Dimensionierung der Ladeöffnung (3) auf die Dimensionierung des Datenspeichers (2) der Art abgestimmt ist, dass die kleinste Seitenfläche des Datenspeichers (2) die Dimensionierung der Größe der Ladeöffnung (3) bestimmt.

10. Elektronisches Gerät zum Lesen und/oder Schreiben von Informationen auf Datenspeicher (2) mit zumindest einem Lademechanismus nach einem der Ansprüche 1 bis 9.
